# EUROPEAN PATENT SPECIFICATION

(11) **EP 2 374 590 B1**
(45) Date of publication and mention of the grant of the patent: **10.09.2014**
(21) Application number: 10729232.8
(22) Date of filing: 07.01.2010
(51) Int. Cl.: B29C 33/68, B29C 45/14, H01L 21/56, H01L 33/54, B29L 31/36

(54) **MOLD-RELEASING FILM AND METHOD FOR MANUFACTURING LIGHT EMITTING DIODE**
FORMTRENNFILM UND VERFAHREN ZUR HERSTELLUNG LICHTEMITTIERENDER DIODEN
FILM DE DÉMOULAGE ET PROCÉDÉ DE FABRICATION DE DIODE ÉLECTROLUMINESCENTE

(30) Priority: 08.01.2009 JP 2009002510
(43) Date of publication of application: 12.10.2011
(73) Proprietor: Asahi Glass Company, Limited, Chiyoda-ku Tokyo 100-8405 (JP)
(72) Inventor: HIGUCHI, Yoshiaki, Tokyo 100-8405 (JP); YUKAWA, Yasumasa, Tokyo 100-8405 (JP)
(74) Representative: Müller-Boré & Partner Patentanwälte PartG mbB
(86) International application number: PCT/JP2010/050116
(87) International publication number: WO 2010/079812

(56) References cited:
- EP-A1- 1 669 191
- WO-A1-2008/020543
- JP-A- H1 140 593
- JP-A- 2007 237 740
- JP-A- 2008 207 450
- JP-A- 2009 119 697
- US-A- 3 454 457
- US-A- 4 359 442
- US-A- 5 460 680

## Description

### TECHNICAL FIELD

The present invention relates to a release film to be placed in a cavity of a mold for forming a resin portion to seal a light emitting element for a light emitting diode, and a process for producing a light emitting diode by employing the release film.

### BACKGROUND ART

A light emitting diode is used for e.g. various illuminations, signboards, backlights for liquid crystal display panels or tail lamps for automobiles since high brightness can be obtained at a low power and further a life span is long. A light emitting diode is an element in which a binding energy between an electron and a hole is converted to light on the interface formed by bonding a N-type semiconductor and a P-type semiconductor. A light emitting diode attracts attention as a highly reliable energy saving type light source with a low environmental burden since its power consumption is about a half as compared with a fluorescent lamp, it is said that the life span is structurally semipermanent, further no noxious substance such as mercury is contained therein, and heat generation is low.

A light emitting element for a light emitting diode is usually sealed with a heat-resistant transparent resin with low attenuation of light, for the purpose of imparting electrical insulating property to it and protecting it from exterior environment such as water or moisture. As a transparent resin for sealing, e.g. a thermosetting resin such as a silicone resin or an epoxy resin is used. The light emitting diode is produced by e.g. a so-called compression molding method or a transfer molding method, which comprises placing a substrate having a light emitting element connected thereto so that the light emitting element is positioned at a prescribed position in a cavity of a mold, and filling a space in the cavity with a transparent resin to form a resin-sealed portion.

However, since e.g. an interior releasing agent which impairs the transparency of a resin cannot be employed, it is difficult to release a resin-sealed portion from a mold, and the resin-sealed portion tends to be damaged or broken when forcibly released. Accordingly, in such a state that a release film is placed so as to cover the inner surface of a cavity of a mold, the cavity is filled with a transparent resin to form a resin-sealed portion, and then the release film is peeled from the resin-sealed portion.

The releasing property, the heat resistance durable against a temperature (usually, about 130°C) of a mold during molding, and the strength durable against flow of a resin and applied pressure, are required to the release film. At present, as release films excellent in such properties, films made of fluororesins are widely used. Among the fluororesins, an ethylene/tetrafluoroethylene copolymer is widely used as a material for release films for a step of sealing a light emitting diode element with a resin, since elongation is large at a high temperature and the following ability to the shape of a deep cavity is good, in addition to the above properties.

Recently, for the purpose of e.g. expansion of direction of light emitted from a light emitting diode, uniformity in emission brightness and improvement in emission brightness, a light emitting diode having concaves and convexes formed on the surface of a resin-sealed portion has been proposed. As a method for forming the concaves and convexes on the surface of a resin-sealed portion, the following methods may, for example, be mentioned:
(1) A method of bonding a film having concaves and convexes formed on its surface, on the surface of a resin-sealed portion (Patent Document 1)
(2) A method of forming concaves and convexes on the inner surface of a cavity of a mold, and transferring the concaves and convexes to a resin-sealed portion at the time of sealing a resin (Paragraph [0016] in Patent Document 2)

However, by the method (1), the number of components and the number of steps are increased, and therefore the cost increases. Further, the thickness tends to increase due to a thickness of such a concavo-convex film, and therefore the method is not suitable for backlights for liquid crystal display panels which are required to be small in size and to be thin.

By the method (2), when a release film is placed in the cavity of a mold, concaves and convexes on the inner surface of the cavity cannot accurately be transferred to the surface of a resin-sealed portion. On the other hand, if a release film is not placed, the releasing property between a mold and a resin-sealed portion will be poor, whereby the yield tends to decrease.

### PRIOR ART DOCUMENTS

### PATENT DOCUMENTS

Patent Document 1: JP-A-2008-227456
Patent Document 2: JP-A-2003-234509

Further release films are disclosed in US 3 454 457, US 5 460 680, EP 1669191 A, JP 2007 237740 A and JP H11 40593 A.

### DISCLOSURE OF INVENTION

### TECHNICAL PROBLEM

It is an object of the present invention to provide a release film for producing a light emitting diode having desired concaves and convexes accurately transferred directly to the surface of a resin-sealed portion, at a low cost and in high yield, a process for sealing a light emitting element, and a process for producing a light emitting diode.

### SOLUTION TO PROBLEM

The release film of the present invention is a release film which is to be placed in a cavity of a mold to seal a light emitting element of a light emitting diode with a transparent resin by means of a mold, wherein a plurality of convex portions and/or concave portions are formed on at least one surface.

According to the invention, the above convex portions and/or concave portions have inclined surfaces with an inclination angle of from 20 to 75°.

It is preferred that an average interval of adjacent local peaks of the above convex portions or an average interval of adjacent local bottoms of the above concave portions is from 4 to 200 µm, and an average height of the above convex portions or an average depth of the above concave portions is from 2 to 100 µm.

It is preferred that the above convex portions are convex stripes with a triangular cross section or pyramid projections.

It is preferred that the above concave portions are grooves with a V-form cross section or pyramid pores.

Here, the above cross section is a cross section in a direction perpendicular to the longitudinal direction of the convex stripes or the grooves.

It is preferred that the release film of the present invention is made of a fluororesin.

It is preferred that the above fluororesin is an ethylene/tetrafluoroethylene copolymer.

The process for sealing a light emitting element according to claim 7 of the present invention is a process for sealing a light emitting element of a light emitting diode with a transparent resin by means of a mold, which comprises using a release film having a plurality of convex portions and/or concave portions formed on at least one surface, placing the above release film in the cavity of the mold so as to cover the inner surface of the cavity of the mold and so that the surface having the above convex portions and/or concave portions formed thereon faces a space in the cavity, further placing the above light emitting element in the above cavity, and then filling the above cavity with a transparent resin to seal the above light emitting element with the transparent resin.

Further, the process for producing a light emitting diode according to claim 9 of the present invention comprises a step of placing a release film having a plurality of convex portions and/or concave portions formed on its surface so as to cover the inner surface of a cavity of a mold and so that the convex portions and/or concave portions formed on the above surface face a space in the cavity, a step of placing a substrate having a light emitting element connected thereto in the mold so that the light emitting element is positioned at a prescribed position in the cavity of the mold, a step of filling the space in the cavity with a resin to form a resin-sealed portion, a step of taking out the light emitting diode from the mold in such a state that the release film is attached to the resin-sealed portion, and a step of peeling the release film from the resin-sealed portion.

### ADVANTAGEOUS EFFECT OF INVENTION

By means of the release film of the present invention, it is possible to produce a light emitting diode having desired concaves and convexes accurately transferred directly to the surface of a resin-sealed portion, at a low cost and in high yield.

According to the process for producing a light emitting diode of the present invention, it is possible to produce a light emitting diode having desired concaves and convexes accurately transferred directly to the surface of a resin-sealed portion, at a low cost and in high yield.

### BRIEF DESCRIPTION OF DRAWING

Fig. 1 is a cross-sectional view in the vicinity of a surface of the release film of the present invention.
Fig. 2 is an electron microscopic photograph showing a surface of the release film in Example 2.
Fig. 3 is an electron microscopic photograph showing a cross section of the release film in Example 2.
Fig. 4 is an electron microscopic photograph showing a perspective view of a surface of the release film in Example 3.

### DESCRIPTION OF EMBODIMENT

### <Release film>

The release film of the present invention is a film having a plurality of convex portions and/or concave portions (which may be hereinafter collectively referred to also as "concaves and convexes") formed on at least one surface.

The concaves and convexes on the surface of the release film are formed to have a shape which is a reverse of the concaves and convexes to be formed on the surface of a resin-sealed portion of a light emitting diode.

The convex portions may, for example, be long convex stripes extending on the surface of the release film or projections dotted on the surface of the film.

The concave portions may, for example, be long grooves extending on the surface of the release film or pores dotted on the surface of the film.

The shape of the convex stripes or grooves may, for example, be a linear, curved or bent shape. The convex stripes or the grooves may be present in parallel with one another to form stripes.

The cross-sectional shape in a direction perpendicular to the longitudinal direction of the convex stripes or the grooves may, for example, be triangular (a V-form cross section) or semicircular.

The shape of the projections or the pores may, for example, be a triangular pyramid, a quadrangular pyramid, a hexagonal pyramid, a cone, a hemisphere or a polyhedron.

The concaves and convexes have inclined surfaces with an inclination angle of from 20 to 75° from the viewpoint that the surface of the resin-sealed portion can exhibit optical axis control function. By transferring the inclined surfaces to the surface of the resin-sealed portion, a large amount of a vertical component is imparted to omnidirectional light irradiated from a light emitting element on the surface of the resin-sealed portion, whereby front brightness improves. If the inclination angle is less than 20°, optical axis control function tends to be low.

The inclination angle is more preferably at least 30°.

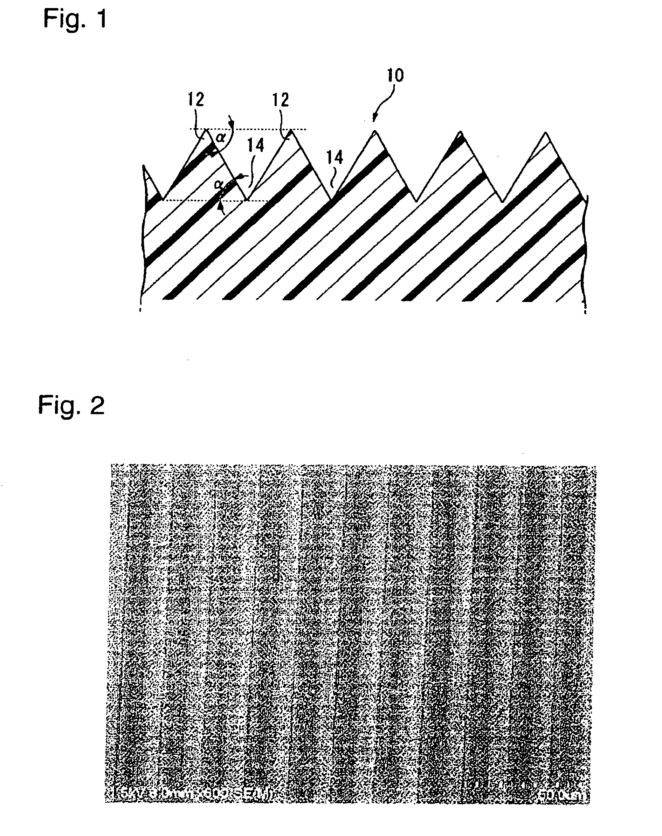

As shown in Fig.1, a line connecting adjacent local peaks of the convex portions (convex stripes 12) of the release film 10 is set to be 0°, and the smallest angle a from the line to the inclined surface is regarded as the inclination angle. When convex portions are not present, a line connecting adjacent local bottoms of the concave portions (grooves 14) is set to be 0°, and the smallest angle α from the line to the inclined surface is regarded as the inclination angle.

The total area of the inclined surface is preferably at least 50%, more preferably at least 67%, to the area (100%) of the surface of a release film having concaves and convexes formed, from the viewpoint that the concave and convex can efficiently be transferred to the surface of the resin-sealed portion. The area of the inclined surface is an area of the portion where the inclined surface is formed, and such an area is different from an actual area of the inclined surface, in which inclination is taken into account.

The concave and convex is preferably in a form of prism shape from the viewpoint that the surface of the resin-sealed portion can efficiently exhibit the optical axis control function.

A prism shape may be a unidirectional triangular prism, a bidirectional prism or a tridirectional prism. In the case of a unidirectional triangular prism, a mold to form concaves and convexes for the release film can easily be prepared, but it has an optical anisotropy. In the case of a bidirectional prism or a tridirectional prism, its optical anisotropy is small, but the cost of a mold to form concaves and convexes for the release film increases. The prism shape is selected depending upon the particular application of a light emitting diode.

As the unidirectional triangular prism, convex stripes with a triangular cross section and/or grooves with a V-form cross section may be mentioned. As shown in Fig. 1, it is more preferred that such convex stripes and/or grooves are formed in such a manner that convex stripes 12 with a triangular cross section and grooves 14 with a V-form cross section are present alternately in parallel.

As the bidirectional prism, quadrangular pyramid projections and/or quadrangular pyramid pores may be mentioned. It is more preferred that the projections and/or pores are formed to be arranged so that a plurality of them are formed at equal intervals and further so that inclined surfaces of adjacent projections and/or pores are positioned on the same plane.

As the tridirectional prism, triangular pyramid projections and/or triangular pyramid pores may be mentioned. It is more preferred that the projections and/or pores are formed to be arranged so that a plurality of them are formed at equal intervals and further so that inclined surfaces of adjacent projections and/or pores are positioned on the same plane.

The concave and convex may be conical projections and/or conical pores from the viewpoint of reduction of optical anisotropy. It is more preferred that the projections and/or pores are formed to be arranged so that a plurality of them are formed at equal intervals.

The average interval of concaves and convexes is preferably from 4 to 200 µm, and further the average height of the convex portions or the average depth of the concave portions is preferably from 2 to 100 µm. The thickness of the release film is at most 150 µm from the viewpoints of costs and following ability to a cavity, therefore in a case where the average interval exceeds 200 µm and the average height (average depth) exceeds 100 µm, a local bottom portion of the release film becomes too thin, and if a film is deformed along the cavity, the local bottom portion is locally stretched, whereby the concave and convex are broken and sometimes destroyed.

The average interval of concaves and convexes is more preferably from 5 to 100 µm, and further the average height of the convex portions or the average depth of the concave portions is more preferably from 4 to 50 µm. Further, the average interval of concaves and convexes is furthermore preferably from 10 to 60 µm, and further the average height of the convex portions or the average depth of the concave portions is more preferably from 5 to 30 µm.

The average interval is a value obtained in such a manner that ten spots among the intervals of adjacent local peaks of the convex portions or the intervals of adjacent local bottoms of the concave portions are measured at random and averaged.

The average height (average depth) is a value obtained in such a manner that ten spots of differences in height between local peaks of the convex portions and local bottoms of the concave portions are measured at random and averaged.

The thickness of the release film is preferably from 10 to 150 µm, more preferably from 25 to 125 µm.

As a material for the release film, a fluororesin having a fluorine atom content being at least 10 mass% is preferred from the viewpoint of the releasing property, the heat resistance, the strength and the elongation at a high temperature. Since a fluorine atom exhibits the highest electronegativity of all the atoms and strong cohesion with an atom bonded therewith, a compound containing fluorine atoms shows a low surface tension, and non-adhesiveness to other materials to be in contact therewith. Further, likewise, such a compound is not readily decomposed by an external energy such as heat or light since it has such a strong cohesion, and therefore has excellent heat resistance. Further, since intramolecular cohesion of a fluororesin is strong, its intermolecular force is inversely weak, and in a case where an external force is applied, molecules slide over one another, whereby the fluororesin exhibits high ductility, i.e. elongation.

The fluororesin having a fluorine atom content of at least 10 mass% may, for example, be polytetrafluoroethylene, a tetrafluoroethylene/propylene hexafluoride copolymer, a tetrafluoroethylene/perfluoroalkoxyethylene copolymer, an ethylene/tetrafluoroethylene copolymer, polyvinylidene fluoride, polyvinyl fluoride, a tetrafluoroethylene/propylene hexafluoride/vinylidene fluoride copolymer, polychlorotrifluoroethylene or an ethylene/chlorotrifluoroethylene copolymer.

The fluororesin may be used alone or in combination of two or more. The fluororesin may be used in combination with a non-fluororesin, or may have e.g. an inorganic additive or an organic additive incorporated.

As the fluororesin, an ethylene/tetrafluoroethylene copolymer is particularly preferred from the viewpoint of large elongation at a high temperature.

As a method for forming concaves and convexes on the surface of a release film, a method of transferring concaves and convexes formed on an original mold, to the surface of the release film by heat processing, may be mentioned, and from the viewpoint of productivity, the following method (i) or (ii) is preferred, and the method (ii) is more preferred.
(i) A method of letting a release film through between an original mold roll and an impression cylinder roll to continuously transfer concaves and convexes which are formed on the surface of the original mold roll, to the surface of the release film.
(ii) A method of letting a resin extruded from a die of an extruder through between an original mold roll and an impression cylinder roll, to form the resin into a film, and at the same time, to continuously transfer concaves and convexes which are formed on the surface of the original mold roll, to the surface of the film-form resin.

By employing a roll-type original mold, continuous processing can be carried out, whereby the productivity of a release film having concaves and convexes formed is remarkably improved, and at the same time, since a release film in a roll-form is obtained, it is possible to employ a compression molding apparatus or a transfer molding apparatus having mechanisms of supplying and winding a general-purpose release film, and therefore resin sealing of a light emitting diode can readily be carried out.

### Method (i):

The surface temperature of the original mold roll is different depending upon the material and the thickness of a release film, but it is preferably from 80 to 300°C.

The pressure applied between the original mold roll and the impression cylinder roll is preferably a linear pressure of from 2 to 100 kg/cm.

The processing speed is preferably from 0.2 to 100 m/min.

### Method (ii):

A resin extruded from a slit of a die is drawn along an original mold roll which is set to be at most the melting point of the resin, whereby the shape is fixed, and at the same time, the thickness is determined by an extrusion amount adjusted by the number of revolutions of a screw of an extruder, a slit width of the die and a drawing speed adjusted by the number of revolutions of the original mold roll.

The surface temperature of the original mold roll, the pressure applied between the original mold roll and the impression cylinder roll, and the processing speed are preferably in the same range as in the method (i).

### Original mold roll:

A material for the original mold roll may, for example, be a metal, ceramics, or a resin, and is preferably a material having a high heat resistance since a heat processing temperature of the fluororesin is relatively high. The heat resistant temperature is preferably at least 300°C. Accordingly, the material for the original mold roll is preferably a metal or ceramics from the viewpoint of heat resistance and durability.

The surface of the original mold roll made of a metal may be subjected to surface modification such as ceramic coating, ceramic sintering, ceramic deposition, ultrahard metal spraying, plating, carburizing or nitriding so as to increase the hardness.

As a method for forming concaves and convexes on the surface of the original mold roll, a method of e.g. cutting or etching may be mentioned.

The concaves and convexes on the surface of the original mold roll have a shape which is a reverse of the concaves and convexes on the surface of the release film, and which is the same shape as the concaves and convexes to be formed on the surface of the resin-sealed portion of the light emitting diode.

### Impression cylinder roll:

As the impression cylinder roll, a rubber-wrapped roll, a resin-wrapped roll, a paper-wrapped roll or a metal roll may, for example, be mentioned, and with a view to suppressing burden to the original mold roll to be low, the rubber-wrapped roll is preferred.

The above-described release film of the present invention has concaves and convexes formed on the surface, and therefore the concaves and convexes can be transferred directly to the surface of the resin-sealed portion by placing the film in the cavity of a metal mold. Further, since the concaves and convexes can be transferred directly to the surface of the resin-sealed portion, it is possible to accurately transfer desired concaves and convexes. Further, since the concaves and convexes can be transferred directly to the surface of the resin-sealed portion, it is possible to produce a light emitting diode at a low cost without increasing the number of components and the number of steps. Further, since the releasability between a mold and a resin-sealed portion is good, it is possible to produce a light emitting diode in high yield.

### <Process for producing light emitting diode>

The process for producing a light emitting diode of the present invention is a process, wherein the release film of the present invention is preliminarily placed in the above cavity, before sealing the light emitting element by a conventional method.

Specifically, a process comprising the following steps (a) to (e) may be mentioned.
(a) A step of placing the release film of the present invention so as to cover the inner surface of a cavity of a mold and so that the concaves and convexes formed on the surface face a space in the cavity.
(b) A step of placing a substrate having a light emitting element connected thereto in the mold so that the light emitting element is positioned at a prescribed position in the cavity of the mold.
(c) A step of filling the space in the cavity with a resin to form a resin-sealed portion.
(d) A step of taking out the light emitting diode from the mold in such a state that the release film is attached to the resin-sealed portion.
(e) A step of peeling the release film from the resin-sealed portion.

A method of forming a resin-sealed portion may be a compression molding method or a transfer molding method. As a production device, a conventional compression molding device or transfer molding device may be used. Production conditions may also be the same as conditions in a conventional process for producing a light emitting diode.

In the above-described process for producing a light emitting diode of the present invention, the release film of the present invention is used, and therefore it is possible to produce a light emitting diode having desired concaves and convexes accurately transferred directly to the surface of a resin-sealed portion at a low cost in high yield.

### EXAMPLES

Now, the present invention will be described in further detail with reference to Examples, but it should be understood that the present invention is by no means restricted to such specific Examples.

Examples 2 and 3 are Examples of the present invention, and Example 1 is Comparative Example.

### EXAMPLE 1

As a release film, an ethylene/tetrafluoroethylene copolymer film (Fluon LM-ETFE film manufactured by Asahi Glass Company, Limited, thickness: 100 pm) was prepared. On the surface of the film, concaves and convexes were not formed.

By the following method, a light emitting element was sealed to obtain a light emitting diode, and the brightness of the light emitting diode was measured.

In the cavity (5 mm square quadrangular) of a mold in which a white light emitting element (operating voltage: 3.5 V, consumption current: 10 mA, size: 0.1 mm square, 0.05 mm thickness) was placed at a center and the above release film was placed so as to be a position of 0.7 mm from the upper surface of the light emitting element, a transparent silicone resin (a mixture of equal amounts of LPS-3412A and LPS-3412B, manufactured by Shin-Etsu Chemical Co., Ltd.) was injected and cured to form a resin-sealed portion. At that time, the temperature of the mold was set to 130°C, the pressure was set to 5 MPa, and the curing time was set to 3 minutes. Then, a molded product was taken out from the mold, and the release film was peeled from the resin-sealed portion.

Then, the above molded product was cut into 3 mm in diameter with the light emitting element being at a center, and the side surfaces and the bottom surface were subjected to dip coating by a titanium oxide-containing silicone resin with a visible light reflectance of 85% with an average thickness of 0.2 mm, whereby a light emitting diode for measurement was obtained.

### EXAMPLE 2

An apparatus provided with an extruder having a bore diameter of 30 mm, a die having a slit with a width of 250 mm and a gap of 0.5 mm, connected to the tip of the extruder, and a film drawing machine composed of an original mold roll and a rubber-wrapped roll, was prepared.

The original mold roll was prepared as follows.

On the surface of a carbon steel-made metal roll with an outer diameter of 150 mm, having a structure which enables a heat transfer oil flow through inside, an electroless plating layer of a nickel-phosphorus compound was provided, followed by grinding to form a plating layer of about 200 µm. The roll was mounted on a precision lathe (manufactured by TOSHIBA MACHINE CO., LTD.), and by means of a turning tool having a cutting edge angle of 90°, continuous grooves with a V-form cross section with an average interval of 20 µm and a depth of 10 µm were formed over the entire periphery of the roll, to obtain an original mold roll having convex stripes with a triangular cross section and grooves with a V-form cross section with an inclination angle of 45° formed alternately in parallel on the surface.

As the rubber-wrapped roll, a roll with an outer diameter of 150 mm obtained by lining the surface of a metal roll with a silicone rubber having a thickness of 5 mm and a rubber hardness of 65 degree, was prepared.

An ethylene/tetrafluoroethylene copolymer (Fluon ETFE LM720 AP, manufactured by Asahi Glass Company, Limited) was charged in the extruder and melted, and then extruded from the die connected to the tip of the extruder. A typical temperature of the extruder and the die was 320°C, and a extrusion amount was 2.2 kg/hour by adjusting the number of revolutions of a screw.

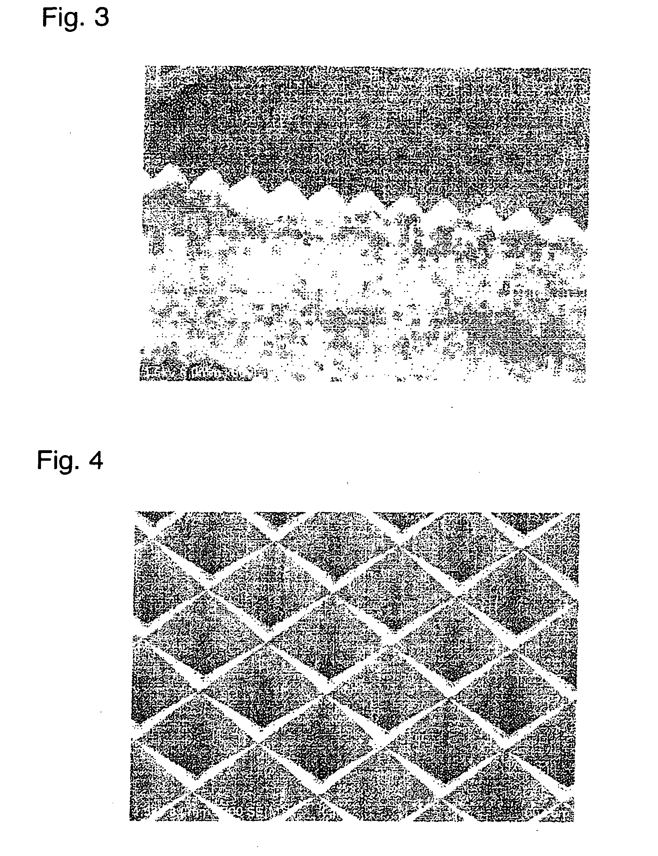

The extruded resin was passed through between the rubber-wrapped roll and the original mold roll pressed by a linear pressure of 10.6 kg/cm to form the resin into a film form, and at the same time, to transfer concaves and convexes formed on the surface of the original mold roll to the surface of the film-form resin to obtain a release film. The surface temperature of the original mold roll was set to 170°C, and the outer peripheral speed of the roll was 2.5 m/min. Electron microscopic photographs of the release film obtained are shown in Fig. 2 and Fig. 3. Here, the magnification of the electron microscopic photographs of Fig. 2 and Fig. 3 is 500 times.

The release film thus obtained was one having a thickness of 60 µm, and having concaves and convexes with an inclination angle of 45°, an average interval of adjacent local peaks of the convex portions being 20 µm and an average depth of the concave portions being 10 µm.

Resin sealing was carried out in the same manner as in Example 1 except that the release film was used, and a light emitting diode having the concaves and convexes on the surface of the release film transferred to the surface of the resin-sealed portion, was obtained. In the case of the light emitting diode in Example 2 in which concaves and convexes (unidirectional triangular prisms) were formed on the surface of the resin-sealed portion, brightness improvement by 8% as a front brightness could be obtained as compared with the case of the light emitting diode in Example 1 in which no concaves and convexes were formed on the surface of the resin-sealed portion.

### EXAMPLE 3

On the surface of a stainless steel material of 100 mm x 100 mm x 10 mm thickness, an electroless plating layer of nickel-phosphorus with a thickness of 200 µ was formed, and the surface was ground to form quadrangular pyramid projections having average intervals of 50 µm in both lengthwise and crosswise directions, a height of 25 µ and an inclination angle of 45° to obtain an original mold.

On the original mold, an ethylene/tetrafluoroethylene copolymer film (Fluon LM-ETFE film manufactured by Asahi Glass Company, Limited, thickness: 100 µ) was put, and concaves and convexes formed on the surface of the original mold were transferred to the film by vacuum pressing at a press temperature of 210°C, under an applied pressure of 7.7 kg/cm² for a pressing time of 30 minutes, to obtain a release film. An electron microscopic photograph of the release film is shown in Fig. 4. Here, the magnification of the electron microscopic photographs of Fig. 2 and Fig. 3 is 500 times.

The release film thus obtained had a thickness of 100 µm, and had concaves and convexes with an inclination angle of 45°, an average interval of adjacent local peaks of the concave portions being 50 µm, and an average height of the convex portions being 25 µm.

Resin sealing was carried out in the same manner as in Example 1 except that the release film was used, and a light emitting diode having the concaves and convexes on the surface of the release film transferred to the surface of the resin-sealed portion, was obtained. In the case of the light emitting diode in Example 3 in which concaves and convexes (bidirectional prisms) were formed on the surface of the resin-sealed portion, brightness improvement by 12% as a front brightness, could be obtained as compared with the case of the light emitting diode in Example 1 in which no concaves and convexes were formed on the surface of the resin-sealed portion.

### INDUSTRIAL APPLICABILITY

The release film of the present invention is useful as a release film to be placed in a cavity of a mold for forming a resin-sealed portion to seal a light emitting element of a light emitting diode.

### REFERENCE SYMBOLS

10 release film
12 convex stripes
14 grooves

## Claims

1. A release film which is to be placed in a cavity of a mold to seal a light emitting element of a light emitting diode with a transparent resin by means of a mold, wherein a plurality of convex portions and/or concave portions are formed on at least one surface, wherein the above convex portions and/or concave portions have inclined surfaces with an inclination angle of from 20 to 75°.

2. The release film according to Claim 1, wherein an average interval of adjacent local peaks of the above convex portions or an average interval of adjacent local bottoms of the above concave portions is from 4 to 200 µm, and an average height of the above convex portions or an average depth of the above concave portions is from 2 to 100 µm.

3. The release film according to Claim 1 or 2, wherein the above convex portions are convex stripes with a triangular cross section, and the above concave portions are grooves with a V-form cross section.

4. The release film according to Claim 1 or 2, wherein the above convex portions are pyramid projections, and the above concave portions are pyramid gaps.

5. The release film according to any one of Claims 1 to 4, which is made of a fluororesin.

6. The release film according to Claim 5, wherein the above fluororesin is an ethylene/tetrafluoroethylene copolymer.

7. A process for sealing a light emitting element, which is a process for sealing a light emitting element of a light emitting diode with a transparent resin by means of a mold, which comprises using a release film having a plurality of convex portions and/or concave portions formed on at least one surface wherein the above convex portions and/or concave portions have inclined surfaces with an inclination angle of from 20 to 75°, placing the above release film in a cavity of the mold so as to cover the inner surface of the cavity of the mold and so that the surface having the above convex portions and/or concave portions formed thereon faces a space in the cavity, further placing the above light emitting element in the above cavity, and then filling the above cavity with a transparent resin to seal the above light emitting element with the transparent resin.

8. The process for sealing a light emitting element according to Claim 7, wherein the release film is made of a fluororesin.

9. A process for producing a light emitting diode, which comprises a step of placing a release film having a plurality of convex portions and/or concave portions formed on its surface wherein the above convex portions and/or concave portions have inclined surfaces with an inclination angle of from 20 to 75° so as to cover the inner surface of a cavity of a mold and so that the convex portions and/or concave portions formed on the above surface face a space in the cavity, a step of placing a substrate having a light emitting element connected thereto in the mold so that the light emitting element is positioned at a prescribed position in the cavity of the mold, a step of filling the space in the cavity with a resin to form a resin-sealed portion, a step of taking out the light emitting diode from the mold in such a state that the release film is attached to the resin-sealed portion, and a step of peeling the release film from the resin-sealed portion.

## Patentansprüche

1. Trennfolie, welche in der Kavität einer Form angeordnet wird, um ein Lichtemittierendes Element einer Licht-emittierenden Diode mit einem transparenten Harz mittels einer Form zu versiegeln, wobei eine Vielzahl von konvexen Abschnitten und/oder konkaven Abschnitten auf mindestens einer Oberfläche gebildet sind, wobei die vorstehenden konvexen Abschnitte und/oder konkaven Abschnitte geneigte Oberflächen mit einem Neigungswinkel von 20° bis 75° aufweisen.

2. Trennfolie gemäß Anspruch 1, wobei ein durchschnittlicher Intervall von angrenzenden lokalen Peaks der vorstehenden konvexen Abschnitte oder ein durchschnittlicher Intervall von angrenzenden lokalen Böden der vorstehenden konkaven Abschnitte von 4 bis 200 µm beträgt und eine durchschnittliche Höhe der vorstehenden konvexen Abschnitte oder eine durchschnittliche Tiefe der vorstehenden konkaven Abschnitte von 2 bis 100 µm beträgt.

3. Trennfolie gemäß Anspruch 1 oder 2, wobei die vorstehenden konvexen Abschnitte konvexe Streifen mit einem triangulären Querschnitt sind und die vorstehenden konkaven Abschnitte Rillen bzw. Furchen mit einem V-förmigen Querschnitt sind.

4. Trennfolie gemäß Anspruch 1 oder 2, wobei die vorstehenden konvexen Abschnitte pyramidale Vorsprünge sind und die vorstehenden konkaven Abschnitte pyramidale Aussparungen sind.

5. Trennfolie gemäß einem der Ansprüche 1 bis 4, welche aus einem Fluorharz ist.

6. Trennfolie gemäß Anspruch 5, wobei das vorstehende Fluorharz ein Ethylen/Tetrafluorethylencopolymer ist.

7. Verfahren zum Versiegeln eines Licht-emittierenden Elements, welches ein Verfahren zum Versiegeln eines Licht-emittierenden Elements einer Licht-emittierenden Diode mit einem transparenten Harz mittels einer Form ist, welches das Verwenden einer Trennfolie mit einer Vielzahl von konvexen Abschnitten und/oder konkaven Abschnitten, gebildet auf mindestens einer Oberfläche, wobei die vorstehenden konvexen Abschnitte und/oder konkaven Abschnitte geneigte Oberflächen mit einem Neigungswinkel von 20 bis 75° aufweisen, das Anordnen der vorstehenden Trennfolie in einer Kavität der Form, um derart die innere Oberfläche der Kavität der Form abzudecken und so dass die Oberfläche mit den vorstehenden konvexen Abschnitten und/oder konkaven Abschnitten gebildet darauf einem Raum in der Form gegenüberliegt, weiter das Anordnen des vorstehenden Licht-emittierenden Elements in der vorstehenden Kavität und anschließend das Füllen der vorstehenden Kavität mit einem transparenten Harz, um das vorstehende Licht-emittierende Element mit dem transparenten Harz zu versiegeln, umfasst.

8. Verfahren zum Versiegeln eines Licht-emittierenden Elements gemäß Anspruch 7, wobei die Trennfolie aus einem Fluorharz ist.

9. Verfahren zur Herstellung einer Licht-emittierenden Diode, welches einen Schritt des Anordnens einer Trennfolie mit einer Vielzahl von konvexen Abschnitten und/oder konkaven Abschnitten gebildet auf deren Oberfläche, wobei die vorstehenden konvexen Abschnitte und/oder konkaven Abschnitte geneigte Oberflächen mit einem Neigungswinkel von 20 bis 75 aufweisen, um derart die innere Oberfläche einer Kavität einer Form abzudecken und so dass die konvexen Abschnitte und/oder konkaven Abschnitte gebildet auf der vorstehenden Oberfläche einem Raum in der Kavität gegenüberliegen, einen Schritt des Anordnens eines Substrats mit einem Licht-emittierenden Element daran verknüpft in der Form, so dass das Licht-emittierende Element in einer vorgeschriebenen Position in der Kavität der Form angeordnet wird, einen Schritt des Füllens des Raums in der Kavität mit einem Harz, um einen Harz-versiegelten Abschnitt zu bilden, einen Schritt des Herausnehmens der Licht-emittierenden Diode aus der Form in einem solchen Zustand, dass die Trennfolie an den Harz-versiegelten Abschnitt gebunden ist, und einen Schritt des Abschälens der Trennfolie von dem Harz-versiegelten Abschnitt umfaßt.

## Revendications

1. Film de démoulage qui doit être placé dans une cavité d'un moule afin de sceller un élément émetteur de lumière d'une diode électroluminescente avec une résine transparente au moyen d'un moule, dans lequel une pluralité de parties convexes et/ou de parties concaves sont formées sur au moins une surface, dans lequel les précédentes parties convexes et/ou parties concaves comportent des surfaces inclinées avec un angle d'inclinaison compris entre 20 et 75°.

2. Film de démoulage selon la revendication 1, dans lequel un intervalle moyen de crêtes locales adjacentes des précédentes parties convexes ou un intervalle moyen des creux locaux adjacents des précédentes parties concaves est compris entre 4 et 200 µm, et une hauteur moyenne des précédentes parties convexes ou une profondeur moyenne des précédentes parties concaves est comprise entre 2 et 100 µm.

3. Film de démoulage selon la revendication 1 ou 2, dans lequel les précédentes parties convexes sont des bandes convexes avec une section transversale triangulaire, et les précédentes parties concaves sont des rainures présentant une section transversale en forme de V.

4. Film de démoulage selon la revendication 1 ou 2, dans lequel les précédentes parties convexes sont des saillies pyramidales, et les précédentes parties concaves sont des trous pyramidaux.

5. Film de démoulage selon les revendications 1 à 4, qui est réalisé à base de résine fluorée.

6. Film de démoulage selon la revendication 5, dans lequel la précédente résine fluorée est un copolymère éthylène/tétrafluoroéthylène.

7. Procédé de scellement d'un élément émetteur de lumière, qui est un procédé de scellement d'un élément émetteur de lumière d'une diode électroluminescente avec une résine transparente au moyen d'un moule, qui comprend l'utilisation d'un film de démoulage présentant une pluralité de parties convexes et/ou de parties concaves formées sur au moins une surface, dans lequel les précédentes parties convexes et/ou parties concaves comportent des surfaces inclinées ayant un angle d'inclinaison compris entre 20 et 75°, la mise en place du précédent film de démoulage dans une cavité du moule de manière à recouvrir la surface interne de la cavité du moule et de telle sorte que la surface comportant les précédentes parties convexes et/ou parties concaves formées dessus se trouve face à un espace dans la cavité, la mise en place en outre de l'élément émetteur de lumière dans la précédente cavité et ensuite le remplissage de la précédente cavité avec une résine transparente afin de sceller le précédent élément émetteur de lumière avec la résine transparente.

8. Procédé de scellement d'un élément émetteur de lumière selon la revendication 7, dans lequel le film de démoulage est à base d'une résine fluorée.

9. Procédé de production d'une diode électroluminescente, qui comprend une étape de mise en place d'un film de démoulage présentant une pluralité de parties convexes et/ou de parties concaves formées sur sa surface, dans lequel les précédentes parties convexes et/ou parties concaves comportent des surfaces inclinées présentant un angle d'inclinaison compris entre 20 et 75°, de manière à recouvrir la surface interne d'une cavité d'un moule et de telle sorte que les parties convexes et/ou parties concaves formées sur la précédente surface se trouvent face à un espace dans la cavité, une étape de mise en place d'un substrat sur lequel un élément émetteur de lumière est couplé dans le moule de telle sorte que l'élément émetteur de lumière se trouve placé à une position prédéterminée dans la cavité du moule, une étape de remplissage de l'espace dans la cavité avec une résine afin de former une partie scellée dans la résine, une étape d'extraction de la diode électroluminescente du moule dans un état tel que le film de démoulage se trouve fixé à la partie scellée dans la résine, et une étape de séparation du film de démoulage par rapport à la partie scellée dans la résine.
